# EUROPEAN PATENT APPLICATION

(11) **EP 4 412 409 A1**
(43) Date of publication of application: **07.08.2024**
(21) Application number: 22892573.1
(22) Date of filing: 25.10.2022
(51) Int. Cl.: H05K 1/18, H05K 1/02

(54) **MOUNTING BOARD, AND ELECTRIC APPARATUS EQUIPPED WITH MOUNTING BOARD**

(30) Priority: 10.11.2021 JP 2021183736
(71) Applicant: OMRON Corporation, Kyoto 600-8530 (JP)
(72) Inventor: MISHIMA, Junya, Kyoto-shi, Kyoto 600-8530 (JP); KUMAGAI, Takuji, Tokyo 108-0075 (JP); KYUNO, Takahiro, Tokyo 108-0075 (JP); MATSUNAGA, Satoshi, Kyoto-shi, Kyoto 600-8530 (JP); NOSAKA, Noriyuki, Kyoto-shi, Kyoto 600-8530 (JP)
(74) Representative: Isarpatent
(86) International application number: PCT/JP2022/039629
(87) International publication number: WO 2023/085073

(57) **Abstract**

Provided is a mounting board and an electric apparatus equipped with the mounting board capable of preventing an electronic component from being damaged due to strain in the printed circuit board caused by contact between the printed circuit board and the electronic component when the printed circuit board mounted with the electronic component is screwed to a heat sink. The mounting board includes an electronic component, a printed circuit board on which the electronic component is mounted, and a heat dissipation component against which the electronic component is pressed. An area of the printed circuit board on which the electronic component is mounted has a distance-increasing structure being predetermined and increasing a distance between a bottom surface of the electronic component and the printed circuit board compared to when the electronic component is mounted on another area.

## Description

### TECHNICAL FIELD

The present invention relates to a mounting board and an electric apparatus equipped with the mounting board.

### BACKGROUND ART

A semiconductor device that can greatly enhance heat dissipation of an electronic component has been known. This semiconductor device includes an electronic component, a board on which the electronic component is mounted, a lower housing on which the board is mounted, and a heat spreader to which the electronic component is metal-bonded with a bonding material therebetween on a first surface thereof. The lower housing has an opening portion for engaging the heat spreader, and the heat spreader is bonded at the opening portion with a bonding material therebetween. A second surface of the heat spreader, which faces the first surface, is exposed from the lower housing (see, for example, Patent Document 1).

Also known is a printed circuit board that makes it possible to reduce damage due to strain caused by screwing stress. This printed circuit board has multiple screw holes and slits formed around the screw holes, which are formed in the vicinity of an outer edge of the printed circuit board. The slit is formed so as to surround the screw hole, and a screw fixing area formed inside surrounded by the slit is connected to an area on the opposite side with the slit therebetween at only one connecting portion at the outer edge of the printed circuit board (see, for example, Patent Document 2).

### CITATION LIST

### PATENT LITERATURE

Patent Document 1: JP 2014-003258 A
Patent Document 2: JP 2016-162944 A

### SUMMARY OF INVENTION

### TECHNICAL PROBLEM

In the semiconductor device disclosed in Patent Document 1, the electronic component is bonded to the heat spreader that has a property of diffusing heat into the atmosphere with a bonding material therebetween in order to greatly enhance the heat dissipation of the electronic component that generates a large amount of heat when current is applied. A configuration is conceivable in which, for example, the board on which the electronic component is mounted is fixed to the heat spreader by screwing so that the electronic component is more tightly bonded to the heat spreader with the bonding material therebetween. However, in this case, when the distance between the electronic component and the board is not sufficient, the electronic component and the board may come into contact with each other, causing strain in the board, and this strain may damage a component such as a ceramic capacitor mounted on the board. According to the printed circuit board disclosed in Patent Document 2, when screwing the printed circuit board to a mounting post or the like, stress is concentrated on the connecting portion at the outer edge of the printed circuit board, and the direction of the stress is along the outer edge of the printed circuit board rather than toward the inside, where an electronic component and the like are mounted. Thus, the stress is not transmitted to a central area of the printed circuit board where the electronic component and the like are mounted, reducing damage due to strain. However, since the slits are formed around the screw holes in the printed circuit board, the strength around the slits decreases, making the board more likely to be damaged, or vibration of the printed circuit board increases when vibration is applied to an electric apparatus in which the printed circuit board is incorporated. When damage caused by strain in the printed circuit board can be reduced without forming slits, the cost for forming the slits will not be necessary, which will be more efficient.

The present invention has been made in view of the above problems, and a final object of the present invention is to provide a mounting board and an electric apparatus equipped with the mounting board capable of preventing an electronic component from being damaged due to strain in the printed circuit board caused by contact between the printed circuit board and the electronic component when the printed circuit board mounted with the electric component is screwed to a heat sink (corresponding to the above-described heat spreader).

### SOLUTION TO PROBLEM

According to the present disclosure for solving the above problems, a mounting board includes an electronic component including an electronic element and a package surrounding the electronic element, a printed circuit board on which the electronic component is mounted and with a metal thin film and/or a resist formed on part of a surface of the printed circuit board, and a heat dissipation component having heat dissipation properties and against which the electronic component is pressed with a bonding material sandwiched between the heat dissipation component and the electronic component, in which an area of the printed circuit board on which the electronic component is mounted has a distance-increasing structure being predetermined and increasing a distance between the electronic component and the printed circuit board compared to when the electronic component is mounted on another area.

According to the present disclosure, since the distance between the electronic component and the printed circuit board is sufficient, it is possible to prevent the printed circuit board and the electronic component from coming into contact with each other, causing strain in the printed circuit board, and consequently damaging the electronic component due to this strain. In addition, by pressing the electronic component, which generates a large amount of heat, against the heat dissipation component having heat dissipation properties with the bonding material therebetween, heat can be absorbed by the heat dissipation component, resulting in prevention of overheating of the electronic component.

According to the present disclosure, in the mounting board, the distance between the electronic component and the printed circuit board increased by the distance-increasing structure may be in a range of from 0.2 mm to 1.0 mm. By setting a specific numerical range, it becomes easy to mount the electronic component on the printed circuit board.

According to the present disclosure, the electronic component may include a lead connected to an external circuit as a terminal, and the mounting board may further include a first electrode formed on the surface of the printed circuit board and to which one end of the lead is electrically connected, and a second electrode formed on the surface of the printed circuit board and to which a terminal other than the lead is electrically connected, in which the distance-increasing structure may be a structure in which a thickness of the first electrode is thicker than a thickness of the second electrode. According to this configuration, the electronic component and the printed circuit board can be electrically connected to each other with a simple configuration, and a sufficient distance can be secured between the electronic component and the printed circuit board.

According to the present disclosure, in the mounting board, the metal thin film may not be formed on a projection surface of the electronic component in the surface of the printed circuit board. According to this configuration, a sufficient distance can be secured between the electronic component and the printed circuit board because there is no need to consider the thickness of the metal thin film, and strain in the printed circuit board can be suppressed.

According to the present disclosure, in the mounting board, the distance-increasing structure may be a structure in which the metal thin film is not formed on at least part of a projection surface of the electronic component in the surface of the printed circuit board. According to this configuration, a sufficient distance can be secured between the electronic component and the printed circuit board because there is no need to consider the thickness of the metal thin film, and strain in the printed circuit board can be suppressed.

According to the present disclosure, in the mounting board, the distance-increasing structure may be a structure in which the resist is not formed on at least part of a projection surface of the electronic component in the surface of the printed circuit board. According to this configuration, a sufficient distance can be secured between the electronic component and the printed circuit board because there is no need to consider the thickness of the resist, and strain in the printed circuit board can be suppressed.

According to the present disclosure, in the mounting board, the distance-increasing structure may be a structure in which a recessed portion is formed on at least part of a projection surface of the electronic component in the surface of the printed circuit board. According to this configuration, a sufficient distance between the electronic component and the printed circuit board can be secured by a depth of the recessed portion, and strain in the printed circuit board can be suppressed.

According to the present disclosure, in the mounting board, the printed circuit board may have multiple screw holes for enabling screwing, and may be connectable to the heat dissipation component by passing screws through the multiple screw holes. According to this configuration, it is possible to firmly fix the printed circuit board to the heat dissipation component, and by fixing the printed circuit board to the heat dissipation component, the electronic component is pressed against and brought into close contact with the bonding material, so that heat generated from the electronic component can be absorbed by the heat dissipation component via the bonding material.

According to the present disclosure, an electric apparatus may be an electric apparatus configured to perform power conversion of power supplied from a power supply device, and may include the mounting board described above. According to this configuration, it is possible to diffuse generated heat from the heat dissipation component into the air outside the electric apparatus and to cool the electric apparatus by the outside air. Further, a circuit pattern on the printed circuit board can be mounted on the electric apparatus.

According to the present disclosure, a printed circuit board may be a printed circuit board on which an electronic component is mountable, in which an area on which the electronic component is mounted in a surface on which the electronic component is mounted has a distance-increasing structure being predetermined and increasing a distance between a bottom surface of the electronic component and the printed circuit board compared to when the electronic component is mounted on another area.

According to the present disclosure, after the electronic component is mounted on the printed circuit board, it is possible to secure a sufficient distance between the electronic component and the printed circuit board, and it is possible to prevent the printed circuit board and the electronic component from coming into contact with each other, causing strain in the printed circuit board, and consequently damaging the electronic component due to this strain.

According to the present disclosure, in the printed circuit board, a distance between the electronic component and the printed circuit board increased by the distance-increasing structure may be in a range of from 0.2 mm to 1.0 mm. By setting a specific numerical range, it becomes easy to mount the electronic component on the printed circuit board.

According to the present disclosure, the electronic component may include a lead connected to an external circuit as a terminal, and the printed circuit board may further include a first electrode formed on the surface of the printed circuit board and to which one end of the lead is electrically connected, and a second electrode formed on the surface of the printed circuit board and to which a terminal other than the lead is electrically connected, in which the distance-increasing structure may be a structure in which a thickness of the first electrode is thicker than a thickness of the second electrode. According to this configuration, the electronic component and the printed circuit board can be electrically connected to each other with a simple configuration, and after the electronic component is mounted on the printed circuit board, a sufficient distance can be secured between the electronic component and the printed circuit board.

According to the present disclosure, in the printed circuit board, the distance-increasing structure may be a structure in which the metal thin film is not formed on at least part of an area to be a projection surface of the electronic component in the surface of the printed circuit board. According to this configuration, after the electronic component is mounted on the printed circuit board, a distance between the electronic component and the printed circuit board can be sufficiently secured because there is no need to consider the thickness of the metal thin film, and strain in the printed circuit board can be suppressed.

According to the present disclosure, in the printed circuit board, the distance-increasing structure may be a structure in which the resist is not formed on at least part of an area to be a projection surface of the electronic component in the surface of the printed circuit board. According to this configuration, after the electronic component is mounted on the printed circuit board, a sufficient distance can be secured between the electronic component and the printed circuit board because there is no need to consider the thickness of the resist, and strain in the printed circuit board can be suppressed.

According to the present disclosure, in the printed circuit board, the distance-increasing structure may be a structure in which a recessed portion is formed on at least part of a projection surface of the electronic component in the surface of the printed circuit board. According to this configuration, after the electronic component is mounted on the printed circuit board, a sufficient distance can be secured between the electronic component and the printed circuit board by a depth of the recessed portion, and strain in the printed circuit board can be suppressed.

Note that the means for solving the above problems can be used in combination with each other as much as possible.

### ADVANTAGEOUS EFFECTS OF INVENTION

According to the present invention, in the mounting board, when the printed circuit board on which the electronic component is mounted is screwed to the heat sink, strain in the printed circuit board can be suppressed, and damage to the electronic component due to this strain can be prevented. Further, the mounting board can be mounted on the electric apparatus.

### BRIEF DESCRIPTION OF DRAWINGS

[FIG. 1] FIG. 1 is a schematic cross-sectional view illustrating an example of an entire mounting board according to a first embodiment.
[FIG. 2] FIG. 2 is a schematic cross-sectional view illustrating an enlarged part of the mounting board illustrated in FIG. 1.
[FIG. 3] FIG. 3A and FIG. 3B are graphs showing a relationship between magnitude of torque for a screw and magnitude of strain in a printed circuit board when connecting the printed circuit board to a heat sink in the first embodiment.
[FIG. 4] FIG. 4 is a schematic cross-sectional view illustrating an example of an electric apparatus equipped with the mounting board according to the first embodiment.
[FIG. 5] FIG. 5 is a schematic cross-sectional view illustrating a first variation of the mounting board illustrated in FIG. 2.
[FIG. 6] FIG. 6 is a schematic cross-sectional view illustrating a second variation of the mounting board illustrated in FIG. 2.

### DESCRIPTION OF EMBODIMENTS

### [Application Example]

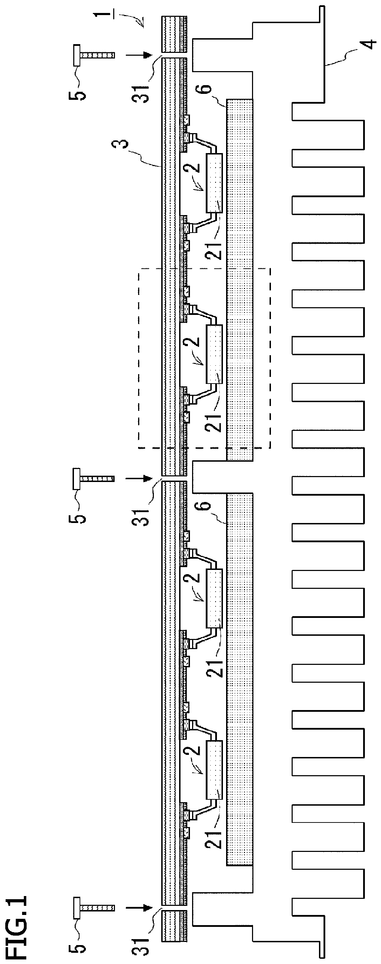

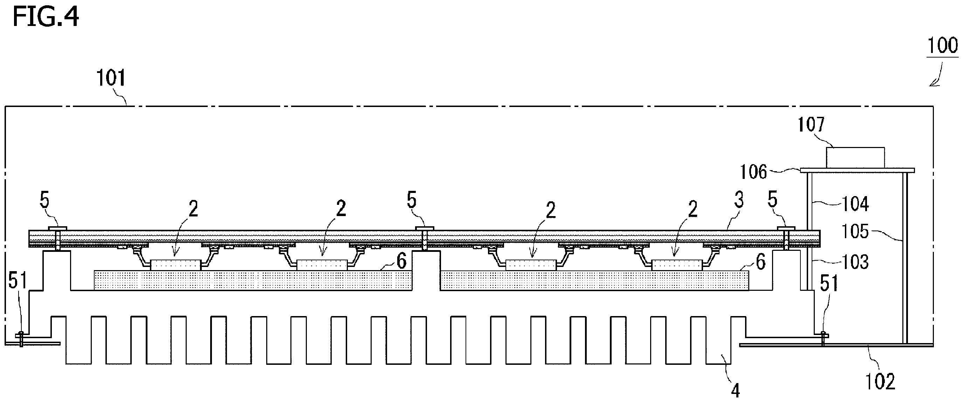

Hereinafter, an overview of an application example of the present invention will be described with reference to accompanied drawings. The present invention can be applied to a mounting board 1 as illustrated in FIG. 1. By mounting the mounting board 1 as illustrated in FIG. 1, the present invention can also be applied to a power conditioner 100 (corresponding to an electric apparatus in the present invention) as illustrated in FIG. 4.

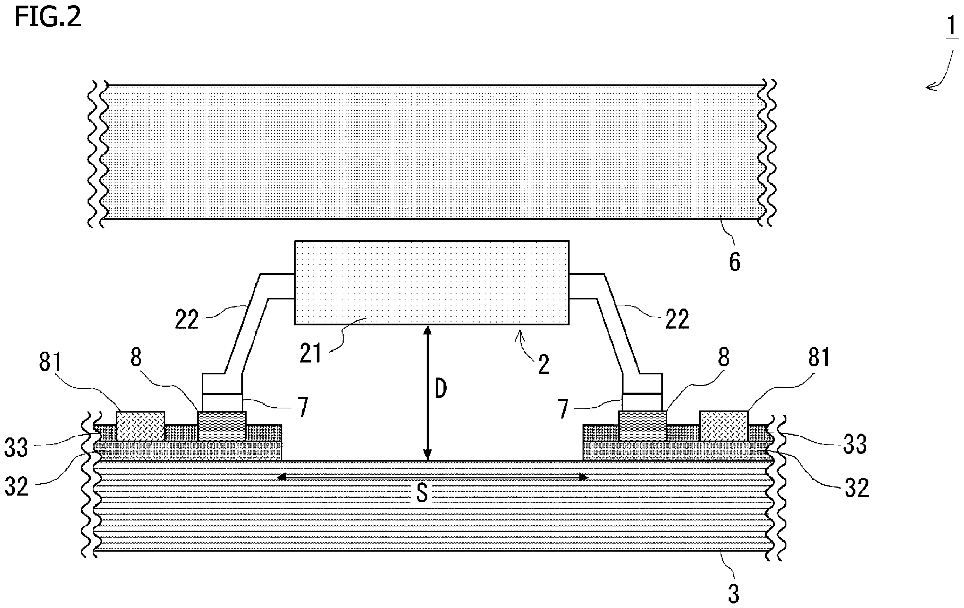

FIG. 1 is a schematic cross-sectional view illustrating an example of the entire mounting board 1 to which the present invention is applicable. The mounting board 1 according to this application example includes an electronic component 2, a printed circuit board 3, a heat sink 4, and the like. FIG. 2 illustrates an enlarged view of part surrounded by a dotted line illustrated in FIG. 1, and other components of the mounting board 1 will be described below with reference to FIG. 2.

The electronic component 2 is, for example, a semiconductor integrated circuit such as an application specific integrated circuit (ASIC) or a power semiconductor such as a metal oxide semiconductor field effect transistor (MOSFET), and includes an electronic element (not illustrated) and a package 21 formed so as to surround the electronic element. By passing current through the electronic element, the electronic component 2 generates heat. Although the mounting board 1 includes electronic components (such as a capacitor) other than the electronic component 2, the electronic component 2 generates a larger amount of heat than the other electronic components.

The printed circuit board 3 may be, for example, a build-up printed circuit board having a multilayer structure and using a thermosetting epoxy resin as a base material. The electronic component 2 is mounted so as to face the printed circuit board 3 with a certain distance therebetween. The printed circuit board 3 has multiple screw holes 31, and the mounting board 1 can be connected to the heat sink 4 by passing screws 5 through the screw holes 31 and fastening the screws 5. The heat sink 4 is mainly made of metal having high thermal conductivity, and has a property of diffusing absorbed heat to the surroundings. Here, the heat sink 4 corresponds to a heat dissipation component in the present invention.

The electronic component 2 is pressed against the heat sink 4 with a heat dissipation sheet 6 therebetween when the mounting board 1 is connected to the heat sink 4 by screwing. The heat dissipation sheet 6 contains a filler such as boron nitride or alumina, which has high thermal conductivity, and absorbs heat generated from the electronic component 2 when current is applied. The absorbed heat is then dissipated to the heat sink 4, and the heat sink 4 diffuses the heat to the surroundings as described above. The heat sink 4 is hard and does not easily deform when the heat dissipation sheet 6 is pressed against the heat sink 4. On the other hand, the heat dissipation sheet 6 has properties as a cushioning material and is easily deformed when pressed against the heat sink 4. Therefore, as compared to a case in which the electronic component 2 is directly pressed against the heat sink 4, the electronic component 2 is more likely to come into close contact with the heat dissipation sheet 6 by being pressed against the heat dissipation sheet 6, and heat is easily absorbed from the electronic component 2. As a result, an amount of heat that the heat sink 4 diffuses to the surroundings also increases. It is also possible to prevent the electronic component 2 from being pressed against the heat sink 4 and being damaged. Here, the heat dissipation sheet 6 corresponds to a bonding material in the present invention.

As described above, when connecting the printed circuit board 3 to the heat sink 4 by screwing, the printed circuit board 3 and the electronic component 2 may come into contact with each other, causing strain in the printed circuit board 3, and this strain may damage the electronic component 2. As a means for suppressing strain in the printed circuit board 3, when the electronic component 2 is mounted on the printed circuit board 3, a distance between the electronic component 2 and the printed circuit board 3 is set within a certain range. Details will be described in a first embodiment below with reference to FIG. 2.

FIG. 2 is a schematic cross-sectional view illustrating an enlarged part of the mounting board 1 illustrated in FIG. 1 surrounded by a dotted line. Note that when the electronic component 2 is mounted on the printed circuit board 3, the printed circuit board 3 is commonly positioned on a lower side, so that the mounting board 1 is illustrated in FIG. 2 upside down compared to FIG. 1. In addition to the components illustrated in FIG. 1, the mounting board 1 according to this application example includes a first electrode 8, a second electrode 81, and the like.

The electronic component 2 has leads 22 connected as terminals. The lead 22 extends from the inside to the outside of the package 21 of the electronic component 2, and partially formed in a gull wing shape. One end of the lead 22 is electrically connected to the first electrode 8 via solder 7. The solder 7 is printed by, for example, a solder paste printer or the like. On part of a surface of the printed circuit board 3 (hereinafter, a surface of the printed circuit board 3 on which the electronic component 2 is mounted will be referred to as "surface of the printed circuit board 3"), a copper foil 32, which is a conductive metal film, and a resist 33, which is an insulating protective film, are formed in this order. The copper foil 32 is formed, for example, by immersing the printed circuit board 3 in a plating solution and reducing copper ions in the plating solution. The resist 33 is, for example, thermocompression bonded to the printed circuit board 3 and subjected to pattern exposure and etching to form a circuit pattern. The copper foil 32 has a thickness of about 70 µm, and the resist 33 has a thickness of about 50 µm. The first electrode 8 and the second electrode 81 are formed on the surface of the printed circuit board 3 passing through the resist 33 and with the copper foil 32 therebetween. The first electrode 8 is electrically connected to one end of the lead 22 via the solder 7 as described above, whereas the second electrode 81 is electrically connected to an electric element not included in the electronic component 2 (such as an arithmetic element). Here, the copper foil 32 corresponds to a metal thin film in the present invention.

### [First Embodiment]

Hereinafter, the mounting board 1 according to the first embodiment of the present invention and the power conditioner 100 as an example of the electric apparatus will be described in more detail with reference to the drawings (including the drawings once described in the application example). Note that the mounting board 1 according to the present invention and the power conditioner 100 are not intended to be limited to the following configurations.

### <Configuration of Printed Circuit Board>

Now, the description returns to FIG. 2. As described in the above-described application example, when mounting the electronic component 2 on the printed circuit board 3, strain in the printed circuit board 3 can be suppressed by having a distance-increasing structure being predetermined in an area in which the electronic component 2 is mounted on the printed circuit board 3 so that a distance D between the electronic component 2 and the printed circuit board 3 is within a certain range. For example, as illustrated in FIG. 2, by not forming the copper foil 32 and the resist 33 on a projection surface S of the electronic component 2 in the surface of the printed circuit board 3, the distance D can be made sufficiently large, and strain in the printed circuit board 3 caused by contact between the printed circuit board 3 and the electronic component 2 can be suppressed. Note that even when the copper foil 32 and the resist 33 are formed on the projection surface S, the copper foil 32 and the resist 33 can be removed by treatment with a stripping solution or the like. By making the distance D sufficiently large, it is possible to prevent the electronic element of the electronic component 2 from being damaged due to strain in the printed circuit board 3 when the printed circuit board 3 is connected to the heat sink 4. Note that in FIG. 2, either the copper foil 32 or the resist 33 may be formed on the projection surface S.

### <Example of Effect Verification>

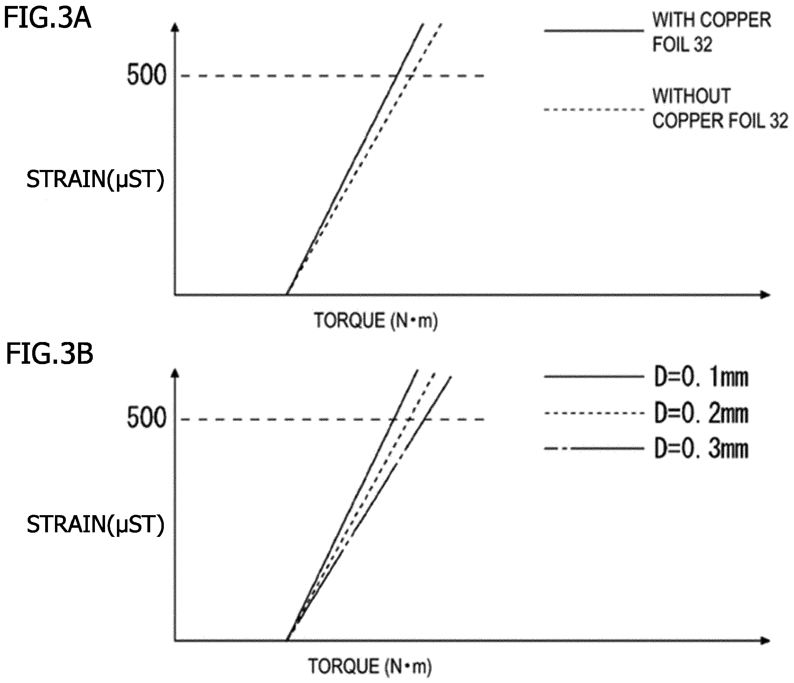

FIG. 3A and FIG. 3B are graphs showing a relationship between magnitude of torque for the screw 5 and magnitude of strain in the printed circuit board 3 when connecting the printed circuit board 3 to the heat sink 4 in the first embodiment of the present invention. In both the graphs in FIG. 3A and FIG. 3B, it is clear that as the torque for the screw 5 increases, the strain in the printed circuit board 3 tends to increase. FIG. 3A is a graph for a condition in which the copper foil 32 is formed (solid line) and a condition in which the copper foil 32 is not formed (broken line) on the projection surface S illustrated in FIG. 2. From FIG. 3A, it is clear that, when compared under the same torque magnitude, the distance D illustrated in FIG. 2 is larger under the condition in which the copper foil 32 is not formed, and thus the strain in the printed circuit board 3 is more suppressed. Note that FIG. 3A is a graph for a condition in which the resist 33 is formed on the projection surface S for both the condition in which the copper foil 32 is formed on the projection surface S and the condition in which the copper foil 32 is not formed, but a similar tendency is obtained for a condition in which the resist 33 is not formed.

FIG. 3B is a graph for conditions in which the distance D is 0.1 mm (solid line), 0.2 mm (broken line), and 0.3 mm (alternate long and short dash line). From FIG. 3B, it is clear that, when compared under the same torque magnitude, the larger the distance D is, the more the strain in the printed circuit board 3 is suppressed. Although the graph in FIG. 3B is simplified, as a result of verifying by changing the distance D in increments of 0.05 mm, it has become clear that the strain in the printed circuit board 3 is suppressed by setting the distance D in a range of from 0.2 mm to 1.0 mm, and more preferably in a range of from 0.2 mm to 0.5 mm. In both the graphs in FIG. 3A and FIG. 3B, it is desirable that the strain in the printed circuit board 3 be 500 µST or less.

### <Configuration of Power Conditioner>

FIG. 4 is a schematic cross-sectional view illustrating an example of the power conditioner 100 equipped with the mounting board 1 according to the first embodiment of the present invention. The mounting board 1 may be mounted on an electric apparatus, and the electric apparatus may be, for example, a power conversion device such as the power conditioner 100, a motor drive device, a power supply device, or the like. The power conditioner 100 is connected to a power supply device (not illustrated) such as a photovoltaic cell, and boosts voltage of power supplied from the power supply device, converts into alternating current, removes noise to adjust a waveform, and then supplies alternating current power to a load (not illustrated) or an interconnected power system (not illustrated).

A metal base 102 having thermal conductivity is provided on one side of a housing 101 of the power conditioner 100. The heat sink 4 to which the printed circuit board 3 is connected is screwed to the metal base 102 with second screws 51. In this way, the heat sink 4 that absorbs the heat generated from the electronic component 2 easily transfers the heat to the outside air. The heat transferred to the metal base 102 is further transferred to the housing 101 and cooled by the outside air.

The printed circuit board 3 is screwed to the heat sink 4 with a spacer 103 therebetween. A terminal block 107 is fixedly attached to a base 106, one end of which is screwed to the printed circuit board 3 with a spacer 104 therebetween and another end of which is screwed to the metal base 102 with a spacer 105 therebetween. A control circuit board (not illustrated) may be attached to a surface of the printed circuit board 3 opposite to the surface thereof via a connector (not illustrated). In this way, the circuit pattern on the printed circuit board 3 is connected to the metal base 102.

### [First Variation]

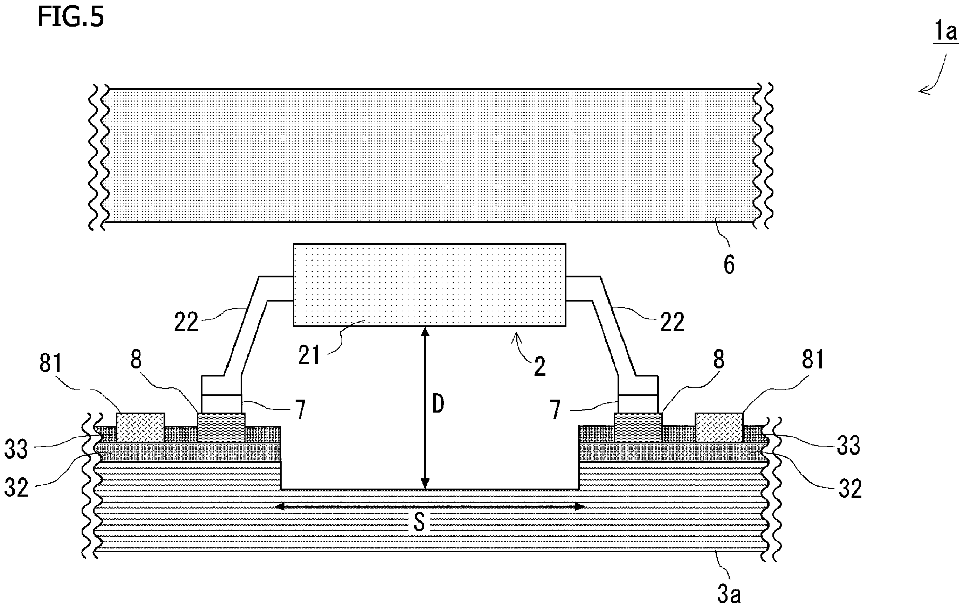

Next, a mounting board 1a according to a first variation of the present invention will be described with reference to FIG. 5. An area in the mounting board 1a where the electronic component 2 is mounted has a distance-increasing structure different from that of the mounting board 1 in the first embodiment. Since the mounting board 1a has many configurations in common with those of the mounting board 1 in the first embodiment, such configurations are denoted by the same symbols and will not be described again. The configuration illustrated in FIG. 5 can also be applied to the mounting board 1 in the first embodiment.

### <Configuration of Printed Circuit Board>

FIG. 5 is a schematic cross-sectional view illustrating the first variation of the mounting board 1 illustrated in FIG. 2. In the mounting board 1a according to the first variation of the present invention, by forming a recessed structure on the projection surface S of the electronic component 2 in a surface of a printed circuit board 3a, a distance D between the electronic component 2 and the printed circuit board 3a can be made sufficiently large, so that strain in the printed circuit board 3a can be suppressed. As means for forming the recessed structure on the surface of the printed circuit board 3a, there are, for example, a method of cutting by router processing, a method of bonding board materials obtained by hollowing out resin layers, such as a cavity board, and the like. Note that as long as the distance D is in a range of 0.2 mm to 1.0 mm, and more preferably in a range of from 0.2 mm to 0.5 mm, the copper foil 32 and/or the resist 33 may be formed on a bottom surface of the recessed structure.

### [Second Variation]

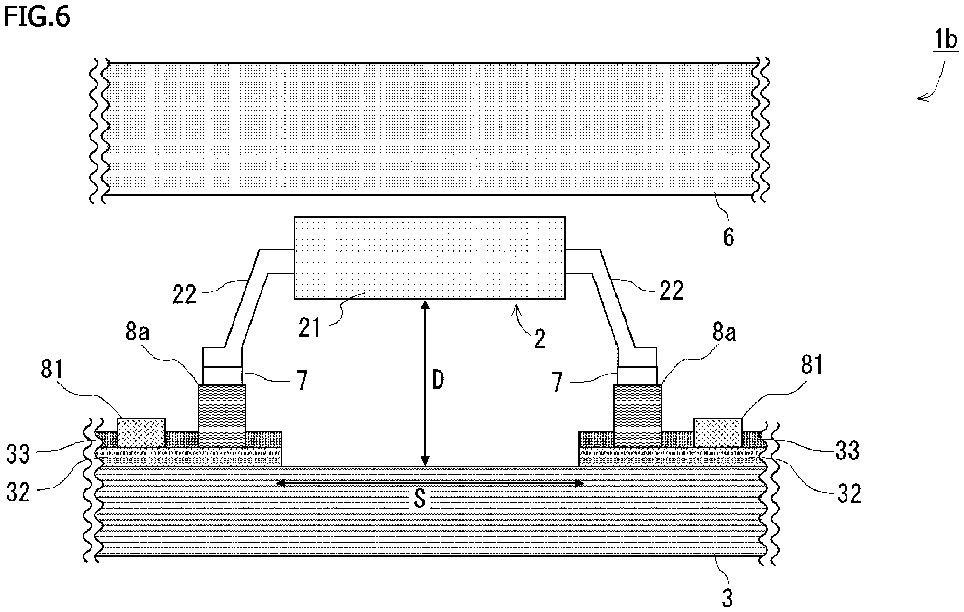

Next, a mounting board 1b according to a second variation of the present invention will be described with reference to FIG. 6. An area in the mounting board 1b where the electronic component 2 is mounted has a distance-increasing structure different from that of the mounting boards 1 and 1a in the first embodiment and the first variation. Since the mounting board 1b has many configurations in common with those of the mounting board 1 in the first embodiment, such configurations are denoted by the same symbols and will not be described again. The configuration illustrated in FIG. 6 can also be applied to the mounting boards 1 and 1a in the first embodiment and the first variation.

### <Configuration of Printed Circuit Board>

FIG. 6 is a schematic cross-sectional view illustrating the second variation of the mounting board 1 illustrated in FIG. 2. In the mounting board 1b according to the second variation of the present invention, by forming a first electrode 8a thicker than the second electrode 81, the distance D between the electronic component 2 and the printed circuit board 3 can be made sufficiently large, so that strain in the printed circuit board 3 can be suppressed. As a means for increasing a thickness of the first electrode 8a, there is, for example, an additive method or the like. Note that as long as the distance D is in a range of 0.2 mm to 1.0 mm, and more preferably in a range of from 0.2 mm to 0.5 mm, the copper foil 32 and/or the resist 33 may be formed on the projection surface S of the electronic component 2 in the surface of the printed circuit board 3.

### <Supplement 1>

A mounting board (1, 1a, 1b) includes an electronic component (2) including an electronic element and a package (21) surrounding the electronic element, a printed circuit board (3, 3a) on which the electronic component is mounted and with a metal thin film (32) and/or a resist (33) formed on part of a surface of the printed circuit board (3, 3a), a heat dissipation component (4) having heat dissipation properties and against which the electronic component is pressed with a bonding material (6) sandwiched between the heat dissipation component (4) and the electronic component, in which an area of the printed circuit board on which the electronic component is mounted has a distance-increasing structure being predetermined and increasing a distance between the electronic component and the printed circuit board compared to when the electronic component is mounted on another area.

### <Supplement 2>

A printed circuit board (3, 3a) on which an electronic component (2) is mountable, in which an area on which the electronic component is mounted in a surface on which the electronic component is mounted has a distance-increasing structure being predetermined and increasing a distance between a bottom surface of the electronic component and the printed circuit board (3, 3a) compared to when the electronic component is mounted on another area.

### Reference SIGNS LIST

- 1, 1a, 1b :: Mounting board

- 2 :: Electronic component
- 21 :: Package
- 22 :: Lead
- 3, 3a :: Printed circuit board
- 31 :: Screw hole
- 32 :: Copper foil
- 33 :: Resist
- 4 :: Heat sink
- 5 :: Screw
- 51 :: Second screw
- 6 :: Heat dissipation sheet
- 7 :: Solder
- 8, 8a :: First electrode
- 81 :: Second electrode
- 100 :: Power conditioner
- 101 :: Housing
- 102 :: Metal base
- 103 to 105 :: Spacer
- 106 :: Base
- 107 :: Terminal block

## Claims

1. Amounting board comprising:
an electronic component including an electronic element and a package surrounding the electronic element;
a printed circuit board on which the electronic component is mounted and with a metal thin film and/or a resist formed on part of a surface of the printed circuit board;
and
a heat dissipation component having heat dissipation properties and against which the electronic component is pressed with a bonding material sandwiched between the heat dissipation component and the electronic component, wherein
an area of the printed circuit board on which the electronic component is mounted has a distance-increasing structure being predetermined and increasing a distance between the electronic component and the printed circuit board compared to when the electronic component is mounted on another area.

2. The mounting board according to claim 1, wherein the distance between the electronic component and the printed circuit board increased by the distance-increasing structure is in a range of from 0.2 mm to 1.0 mm.

3. The mounting board according to claim 1 or 2,
the electronic component includes a lead connected to an external circuit as a terminal, the mounting board further comprising:
a first electrode formed on the surface of the printed circuit board and to which one end of the lead is electrically connected; and
a second electrode formed on the surface of the printed circuit board and to which a terminal other than the lead is electrically connected, wherein
the distance-increasing structure is a structure in which a thickness of the first electrode is thicker than a thickness of the second electrode.

4. The mounting board according to any one of claims 1 to 3, wherein the distance-increasing structure is a structure in which the metal thin film is not formed on at least part of a projection surface of the electronic component in the surface of the printed circuit board.

5. The mounting board according to any one of claims 1 to 4, wherein the distance-increasing structure is a structure in which the resist is not formed on at least part of a projection surface of the electronic component in the surface of the printed circuit board.

6. The mounting board according to any one of claims 1 to 5, wherein the distance-increasing structure is a structure in which a recessed portion is formed on at least part of a projection surface of the electronic component in the surface of the printed circuit board.

7. The mounting board according to any one of claims 1 to 6, wherein the printed circuit board has multiple screw holes for enabling screwing, and is connectable to the heat dissipation component by passing screws through the multiple screw holes.

8. An electric apparatus configured to perform power conversion of power supplied from a power supply device, the electric apparatus comprising:
the mounting board according to any one of claims 1 to 7.

9. A printed circuit board on which an electronic component is mountable, wherein
an area on which the electronic component is mounted in a surface on which the electronic component is mounted has a distance-increasing structure being predetermined and increasing a distance between a bottom surface of the electronic component and the printed circuit board compared to when the electronic component is mounted on another area.

10. The printed circuit board according to claim 9, wherein a distance between the electronic component and the printed circuit board increased by the distance-increasing structure is in a range of from 0.2 mm to 1.0 mm.

11. The printed circuit board according to claim 9 or 10,
the electronic component includes a lead connected to an external circuit as a terminal, the printed circuit board further comprising:
a first electrode formed on the surface of the printed circuit board and to which one end of the lead is electrically connected; and
a second electrode formed on the surface of the printed circuit board and to which a terminal other than the lead is electrically connected, wherein
the distance-increasing structure is a structure in which a thickness of the first electrode is thicker than a thickness of the second electrode.

12. The printed circuit board according to any one of claims 9 to 11, wherein the distance-increasing structure is a structure in which the metal thin film is not formed on at least part of an area to be a projection surface of the electronic component in the surface of the printed circuit board.

13. The printed circuit board according to any one of claims 9 to 12, wherein the distance-increasing structure is a structure in which the resist is not formed on at least part of an area to be a projection surface of the electronic component in the surface of the printed circuit board.

14. The printed circuit board according to any one of claims 9 to 13, wherein the distance-increasing structure is a structure in which a recessed portion is formed on at least part of a projection surface of the electronic component in the surface of the printed circuit board.
